(19) Europäisches Patentamt
European Patent Office
Office européen des brevets

(11) EP 1 143 551 A1

(12) **EUROPÄISCHE PATENTANMELDUNG**

(43) Veröffentlichungstag:
**10.10.2001 Patentblatt 2001/41**

(51) Int Cl.[7]: **H01P 1/15**

(21) Anmeldenummer: **00107389.9**

(22) Anmeldetag: **05.04.2000**

(84) Benannte Vertragsstaaten:
**AT BE CH CY DE DK ES FI FR GB GR IE IT LI LU MC NL PT SE**
Benannte Erstreckungsstaaten:
**AL LT LV MK RO SI**

(71) Anmelder: **Infineon Technologies AG**
**81669 München (DE)**

(72) Erfinder:
- **Zimmermann, Walter**
**83305 Dorfen (DE)**
- **Peichl, Raimund**
**85635 Höhenkirchen-Siegertsbrunn (DE)**
- **Losehand, Reinhard**
**80637 München (DE)**

(74) Vertreter: **Fischer, Volker, Dipl.-Ing. et al**
**Epping Hermann & Fischer**
**Ridlerstrasse 55**
**80339 München (DE)**

(54) **Integrierte Hochfrequenzschaltung**

(57) Ein integriertes Bauelement für Hochfrequenzanwendungen weist einen Schwingkreis (1) auf, zu dem Abstimmdioden (7) und Abgleichdioden (9) parallel geschaltet sind. Durch ein programmierbares Leiternetzwerk wird eine Abgleichspannung am Abgleicheingang (10) erzeugt, durch die ein spezifizierter Zusammenhang zwischen einer an einem Abstimmeingang (8) anliegenden Spannung und der Resonanzfrequenz des Schwingkreises (1) hergestellt werden kann.

FIG 1

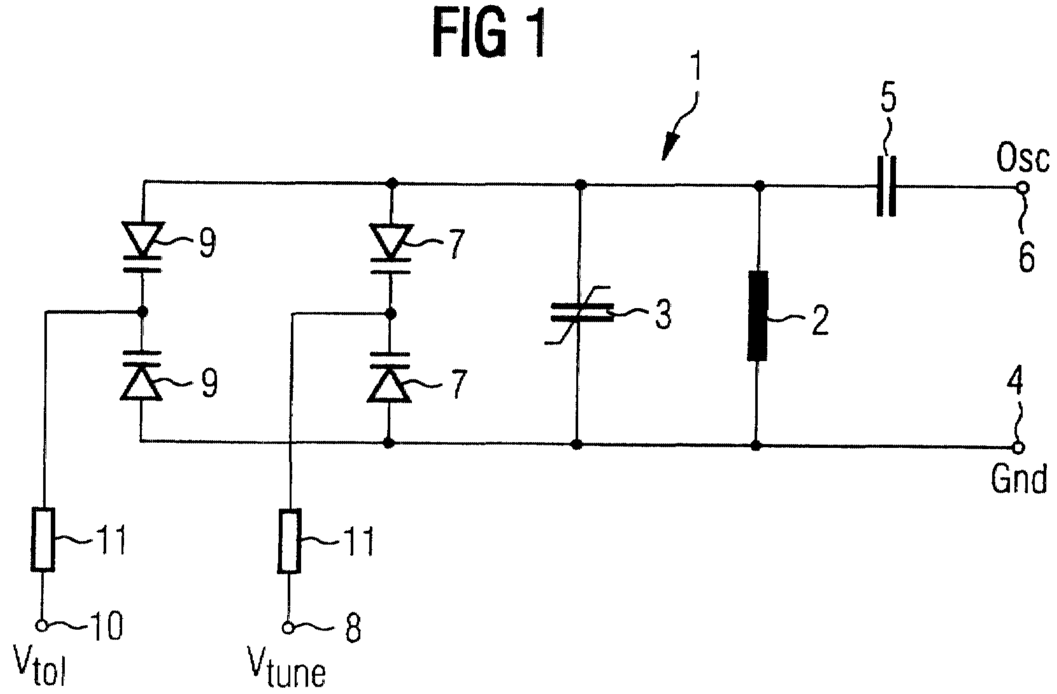


EP 1 143 551 A1

## Beschreibung

Die Erfindung betrifft ein Bauelement mit einer integrierten Hochfrequenzschaltung, die ein Schwingkreis mit einer Kapazität aufweist, deren Wert für einen vorgegebenen Frequenzbereich durch eine Abstimmdiode einstellbar ist.

Bisher werden im Frequenzbereich von 1,5 bis 3 Gigahertz keine integrierten Bauelemente für Schwingkreise oder Signalgeneratoren verwendet. Derzeit kommen entweder diskrete Spulen und Kapazitätsdioden zum Einsatz oder es werden Module aus mehreren integrierten Bauelementen in einem Gehäuse verwendet.

Es besteht jedoch Bedarf an integrierten Bauelementen mit Schwingkreisen oder Signalgeneratoren. Insbesondere werden abstimmbare, spannungsgesteuerte integrierte Bauelemente benötigt. Die üblichen Schaltungen für spannungsgesteuerte Schwingkreise enthalten zumindest eine Abstimmdiode, an denen eine gegen die Flußrichtung gepolte Gleichspannung als Vorspannung anliegt. Die Sperrschichtkapazität der Abstimmdiode ist dann eine monotone Funktion dieser Vorspannung. Der Schwingkreis verfügt daher über eine spannungsgeregelte Kapazität, mit der die Resonanzfrequenz des Schwingkreises eingestellt werden kann. Die Vorspannung dient dabei zum Durchfahren des nutzbaren Frequenzbandes.

Die Spezifikation eines fertigen integrierten Bauelements mit einem Schwingkreis enthält auch einen definierten Zusammenhang zwischen Vorspannung und Resonanzfrequenz. Da jedoch die elektrischen Eigenschaften aller Schaltungselemente in einem Toleranzbereich schwanken können, muß die Möglichkeit bestehen, die Resonanzfrequenz des Schwingkreises abzugleichen.

Aus dem Buch "Microwave and Wireless Synthesizers" von Ulrich L. Rohde, New York 1997, Seiten 62 und 63 ist bekannt, die Feinsteuerung eines Schwingkreises durch eine Abstimmdiode vorzunehmen, an der eine gegen die Flußrichtung gepolte Gleichspannung als Vorspannung anliegt. Parallel zu der Abstimmdiode sind zwei gegeneinander gepolte, zweite und dritte Abstimmdioden vorgesehen, zwischen denen eine Gleichspannung als Vorspannung anliegt, durch die eine Grobsteuerung der Resonanzfrequenz des Schwingkreises vorgenommen werden kann.

Ausgehend von diesem Stand der Technik liegt der Erfindung die Aufgabe zugrunde, ein integriertes Bauelement mit einem abstimmbaren und abgleichbaren, spannungsgesteuerten Schwingkreis zu schaffen.

Diese Aufgabe wird erfindungsgemäß dadurch gelöst, daß die herstellungsbedingten Abweichungen in der Resonanzfrequenz des Schwingkreises durch eine im Schwingkreis angeordnete zweite Abgleichdiode kompensierbar ist, die durch eine Abgleichspannung gesteuert ist, die ein Digital-Analog-Wandler gemäß einem in einem Speicher abgelegten Digitalwert aus einer Referenzspannung erzeugt.

Bei dem Bauelement gemäß der Erfindung genügt es, wenn der Anwender eine vorgegebene Referenzspannung an einen dafür vorgesehenen Eingang des Bauelements anlegt. Das Bauelement erzeugt dann aus der Referenzspannung die für die jeweilige Kompensation erforderliche Abgleichspannung. Der im Speicher abgelegte Digitalwert wird zweckmäßigerweise bei einer Endmessung vor der Auslieferung des Bauelements ermittelt und im Speicher abgelegt. Es genügt daher, daß der Anwender das Bauelement mit einer stabilen Referenzspannung versorgt, um den spezifizierten Zusammenhang zwischen Abstimmspannung und Resonanzfrequenz zu gewährleisten.

Bei einer bevorzugten Ausführungsform der Erfindung ist der Digital-Analog-Wandler durch eine Kette von Längswiderständen bewerkstelligt, zwischen denen Querwiderstände angeschlossen sind, die über Schmelzbrücken wahlweise mit einer Masseleitung oder der Referenzspannung verbindbar sind.

Mit Hilfe der Schmelzbrücken und den Widerständen läßt sich ein einfacher programmierbarer Digital-Analog-Wandler herstellen, der durch Brennen der Schmelzbrücken programmierbar ist.

Weitere zweckmäßige Ausgestaltung sind Gegenstand der abhängigen Ansprüche.

Nachfolgend wird ein Ausführungsbeispiel der Erfindung anhand der beigefügten Zeichnung erläutert. Es zeigen:

| | |
|---|---|
| Figur 1 | die Schaltungsanordnung eines abstimmbaren und abgleichbaren, spannungsgesteuerten Schwingkreises; |
| Figur 2 | die Schaltungsanordnung eines programmierbaren Digital-Analog-Wandlers; und |
| Figur 3a und 3b | Einstellmöglichkeiten für Schmelzbrücken des Digital-Analog-Wandlers aus Figur 2. |

In Figur 1 ist die Schaltungsanordnung eines abstimmbaren und abgleichbaren, spannungsgesteuerten Schwingkreises 1 dargestellt. Der Schwingkreis 1 umfaßt eine Induktivität 2 und eine Kapazität 3 und ist an einen Masseanschluß 4 sowie über einen Koppelkondensator 5 an einen Signalausgang 6 angeschlossen. Parallel zur Kapazität 3 sind zwei gegeneinander gepolte Abstimmdioden 7 geschaltet, zwischen denen eine an einem Abstimmeingang 8 anliegende Abstimmspannung anliegt. Ebenfalls parallel zur Kapazität 3 geschaltet sind gegeneinander gepolte Abgleichdioden 9, zwischen denen eine an einem Abgleicheingang 10 anliegende Abgleichspannung anliegt. Der Abstimmeingang 8 und der Abgleicheingang 10 sind jeweils durch

Vorwiderstände 11 geschützt. Bei den Abstimmdioden 7 und den Abgleichdioden 9 handelt es sich um sogenannte Kapazitätsdioden, deren Sperrschichtkapazität bei Polung gegen die Flußrichtung eine monotone Funktion der an den Kapazitätsdioden anliegenden Spannung ist. Bei der in Figur 1 dargestellten Schaltungsanordnung ist die am Abstimmeingang 8 anliegende Abstimmspannung so groß, daß die Abstimmdioden 7 auf einen Arbeitspunkt eingestellt werden, in dem die Sperrschichtkapazität der Abstimmdioden 7 eine monotone Funktion der am Abstimmeingang 8 anliegenden Abstimmspannung sind. Entsprechend stellt die am Abgleicheingang 10 anliegende Abgleichspannung die Abgleichdioden 9 auf einen Arbeitspunkt ein, in dem die Sperrschichtkapazität der Abgleichdioden 9 eine monotone Funktion der Abgleichspannung ist. Da die Abstimmdioden 7 und die Abgleichdioden 9 durch das vom Schwingkreis 1 erzeugte Wechselstromsignal nur wenig in ihrem Arbeitspunkt ausgelenkt werden, kann die Kapazität der Abstimmdioden 7 und der Abgleichdioden 9 im wesentlichen als konstant angesehen werden. Durch die Abstimmspannung und die Abgleichspannung kann somit die Gesamtkapazität im Schwingkreis 1 gesteuert werden. Insbesondere ist es möglich, durch eine Veränderung der Abstimmspannung die Resonanzfrequenz des Schwingkreises 1 zu verändern.

Bei einem integrierten Bauelement ist es wünschenswert, daß ein spezifizierter Zusammenhang zwischen der jeweiligen Abstimmspannung und der Resonanzfrequenz besteht. Die elektrischen Eigenschaften der Induktivität 2 und der Kapazität 3 sowie der Abstimmdioden 7 schwanken jedoch herstellungsbedingt innerhalb bestimmter vorgegebener Toleranzbereiche. Es ist daher von Vorteil, wenn eine Möglichkeit besteht, diese chwankungen auszugleichen. Diesem Zweck dienen die Abgleichdioden 9, die entsprechend der Abgleichspannung die fertigungsbedingten Toleranzen ausgleichen und auf diese Weise den spezifizierten Zusammenhang zwischen Abgleichspannung und Resonanzfrequenz gewährleisten.

Figur 2 zeigt einen in das Bauelement integrierbaren Digital-Analog-Wandler, der dazu dient, aus einer an einem Referenzeingang 13 anliegenden Referenzspannung die Abgleichspannung an einem Abgleichausgang 14 zu erzeugen.

Der Digital-Analog-Wandler 12 weist ein invers betriebenes programmierbares Leiternetzwerk mit einer Kette von Längswiderständen 15 auf, die an den Abgleichausgang 14 angeschlossen ist. Quer zu den Längswiderständen 15 sind Querwiderstände 16 geschaltet.

Die übrigen Querwiderstände 16 sind über paarweise vorhandene Schmelzbrücken 17 wahlweise mit Masse oder mit dem Referenzeingang verbindbar. Unter Schmelzbrücken 17 sollen sowohl sogenannte Fuses als auch Antifuses verstanden werden. Außerdem sind Schmelzeingänge 18 vorgesehen, die zum Brennen der Schmelzbrücken 17 dienen. Zu diesem Zweck werden an die Schmelzeingänge 18 und den Referenzeingang 13 Spannungen angelegt, deren Höhe so gewählt ist, daß jeweils eine der beiden Schmelzbrücken 17 durchtrennt oder geschlossen wird.

In Figur 3a und 3b sind mögliche Schaltzustände dargestellt. Der Schaltzustand in Figur 3 soll eine logische 1 darstellen, während der Schaltzustand in Figur 3b eine logische 0 darstellt. Für ein Leiternetzwerk mit 2n + 1 Längswiderständen 15 und Querwiderständen 16 und 2n Schmelzbrücken 17, die einen n-Bit Digital-Analog-Wandler darstellen gilt dann:

$$V_{tol} = \frac{V_{ref}}{2^n} \cdot \frac{R_L}{R + R_L} \cdot Z$$

mit

$$Z = \sum_{j=0}^{n-1} z_j 2^j$$

Im Rahmen der Fertigung des integrierten Bauelements kann in einer Endmessung der jeweilige Zusammenhang zwischen der Abstimmspannung und der Resonanzfrequenz des Schwingkreises 1 bestimmt und durch Brennen von Schmelzbrücken 17 kompensiert werden. Von besonderem Vorteil ist, daß der Abgleich mit Hilfe von mitintegrierten Schaltungskomponenten erfolgt.

Bezugszeichenliste

| | |
|---|---|
| 1 | Schwingkreis |
| 2 | Induktivität |
| 3 | Kapazität |
| 4 | Masseanschluß |
| 5 | Koppelkondensator |
| 6 | Signalausgang |
| 7 | Abstimmdiode |
| 8 | Abstimmeingang |
| 9 | Abgleichdioden |
| 10 | Abgleicheingang |
| 11 | Vorwiderstand |
| 12 | Digital-Analog-Wandler |
| 13 | Referenzeingang |
| 14 | Abgleichausgang |
| 15 | Längswiderstand |
| 16 | Querwiderstände |
| 17 | Schmelzbrücke |
| 18 | Schmelzeingang |

**Patentansprüche**

1. Bauelement mit einer integrierten Schaltung für Hochfrequenzanwendungen in einem vorgegebenen Frequenzbereich, wobei die Schaltung einen Schwingkreis (1) mit einer Kapazität aufweist, deren Wert durch eine Abstimmdiode (7) einstellbar ist,
**dadurch gekennzeichnet, daß**
die herstellungsbedingten Abweichungen in der Resonanzfrequenz des Schwingkreises (1) durch eine im Schwingkreis (1) angeordnete zweite Abgleichdiode (9) kompensierbar ist, die durch eine Abgleichspannung gesteuert ist, die ein Digital-Analog-Wandler (12) gemäß einem in einem Speicher (17) abgelegten Digitalwert aus einer Referenzspannung erzeugt.

2. Bauelement nach Anspruch 1,
**dadurch gekennzeichnet, daß**
der Schwingkreis (1) zwei gegeneinander gepolte Abstimmdioden (7) aufweist.

3. Bauelement nach Anspruch 2,
**dadurch gekennzeichnet, daß**
zwischen die Abstimmdioden (7) eine Abstimmspannung angelegt ist.

4. Bauelement nach einem der Ansprüche 1 bis 3,
**dadurch gekennzeichnet, daß**
parallel zur Kapazität des Schwingkreises (1) eine Abgleichdiode (9) geschaltet ist.

5. Bauelement nach Anspruch 4,
**dadurch gekennzeichnet, daß**
zwei gegeneinander gepolte Abgleichdioden (9) parallel zur Kapazität des Schwingkreises (1) geschaltet sind.

6. Bauelement nach Anspruch 5,
**dadurch gekennzeichnet, daß**
zwischen die Abgleichdioden (9) die Abgleichspannung eingespeist ist.

7. Bauelement nach einem der Ansprüche 1 bis 6,
**dadurch gekennzeichnet, daß**
der Digital-Analog-Wandler (12) ein von der Referenzspannung gespeistes Netzwerk aus Widerständen (15, 16) und Schmelzbrücken (17) ist.

8. Bauelement nach Anspruch 7,
**dadurch gekennzeichnet, daß**
der Digital-Analog-Wandler (12) eine Kette von Längswiderständen (15) aufweist, zwischen denen Querwiderstände (16) angeschlossen sind, die über Schmelzbrücken (17) wahlweise an eine Masseleitung oder an die Referenzspannung anschließbar sind.

9. Bauelement nach Anspruch 8,
**dadurch gekennzeichnet, daß**
die Werte der Querwiderstände (16) das zweifache der Längswiderstände (15) betragen.

FIG 1

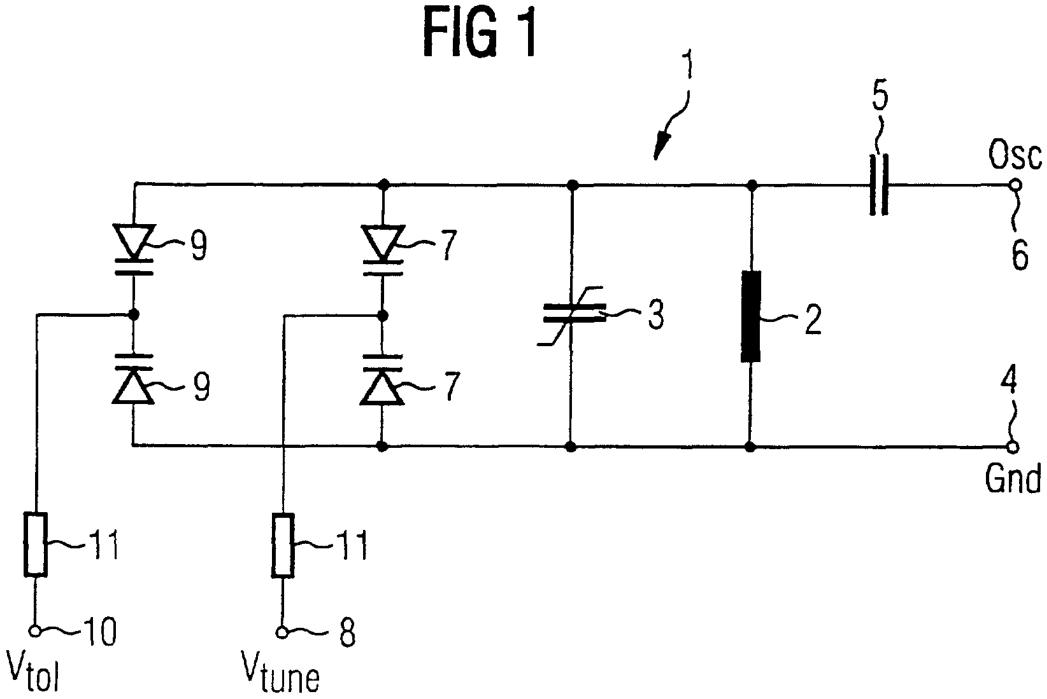

FIG 2

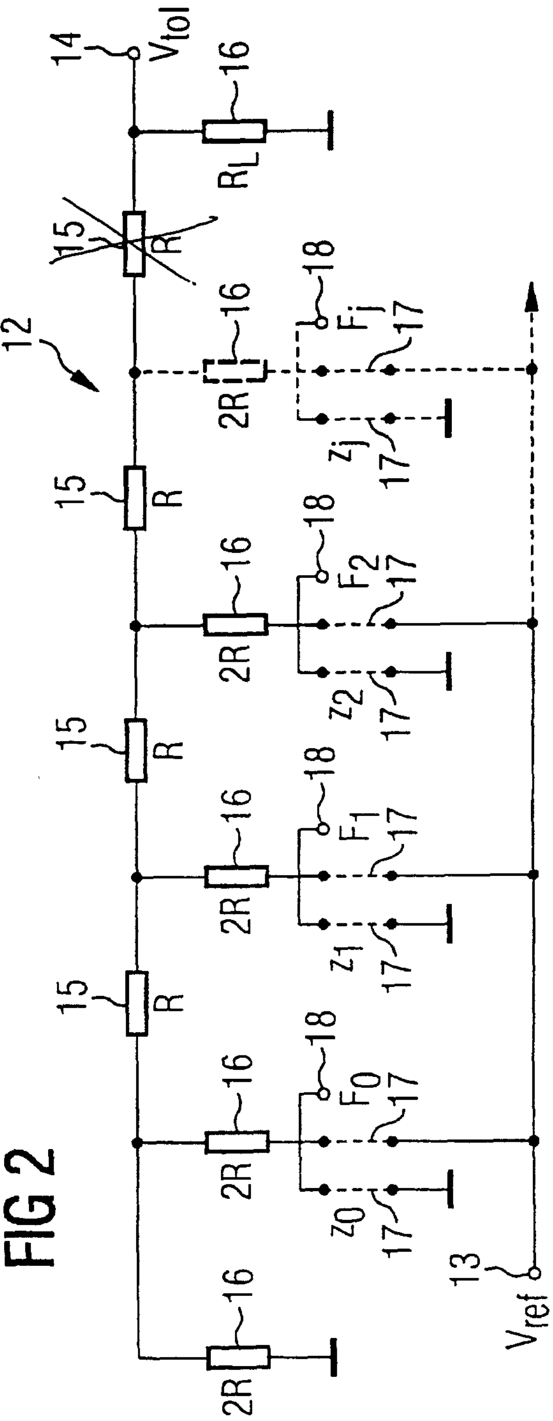


FIG 3A

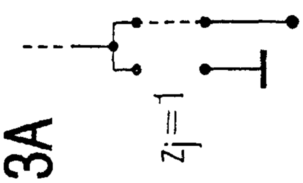


FIG 3B

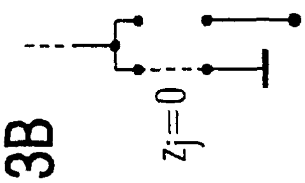

Europäisches Patentamt

# EUROPÄISCHER RECHERCHENBERICHT

Nummer der Anmeldung
EP 00 10 7389

| EINSCHLÄGIGE DOKUMENTE | | | |
|---|---|---|---|
| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
| X | EP 0 409 374 A (MITSUBISHI ELECTRIC CORP) 23. Januar 1991 (1991-01-23) * Spalte 4, Zeile 15 - Spalte 5, Zeile 22; Abbildung 1 * --- | 1-6 | H01P1/15 |
| X | EP 0 364 035 A (PHILIPS ELECTRONICS UK LTD ;PHILIPS NV (NL)) 18. April 1990 (1990-04-18) * Spalte 6, Zeile 42 - Spalte 7, Zeile 32; Abbildung 3 * --- | 1-6 | |
| A | US 4 249 144 A (HURST GEOFFREY J ET AL) 3. Februar 1981 (1981-02-03) * Spalte 1, Zeile 61 - Spalte 4, Zeile 2; Abbildungen 1,2 * ----- | 1-6 | |
| | | | RECHERCHIERTE SACHGEBIETE (Int.Cl.7) |
| | | | H01P |

~~Der vorliegende Recherchenbericht wurde für alle Patentansprüche erstellt~~

| Recherchenort | Abschlußdatum der Recherche | Prüfer |
|---|---|---|
| MÜNCHEN | 4. September 2000 | VILLAFUERTE ABR.., L |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

## ANHANG ZUM EUROPÄISCHEN RECHERCHENBERICHT ÜBER DIE EUROPÄISCHE PATENTANMELDUNG NR. EP 00 10 7389

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

04-09-2000

| Im Recherchenbericht angeführtes Patentdokument | Datum der Veröffentlichung | Mitglied(er) der Patentfamilie | Datum der Veröffentlichung |
|---|---|---|---|
| EP 0409374 A | 23-01-1991 | JP 3049401 A | 04-03-1991 |
| | | DE 69020971 D | 24-08-1995 |
| | | DE 69020971 T | 30-11-1995 |
| | | US 5039873 A | 13-08-1991 |
| EP 0364035 A | 18-04-1990 | GB 2223896 A | 18-04-1990 |
| | | DE 68922177 D | 18-05-1995 |
| | | DE 68922177 T | 02-11-1995 |
| | | JP 2153614 A | 13-06-1990 |
| | | US 4965853 A | 23-10-1990 |
| US 4249144 A | 03-02-1981 | GB 2037514 A | 09-07-1980 |

EPO FORM P0461

Für nähere Einzelheiten zu diesem Anhang : siehe Amtsblatt des Europäischen Patentamts, Nr.12/82